# EUROPÄISCHE PATENTANMELDUNG

(11) **EP 2 747 288 A1**
(43) Veröffentlichungstag der Anmeldung: **25.06.2014**
(21) Anmeldenummer: 12198129.4
(22) Anmeldetag: 19.12.2012
(51) Int. Cl.: H03K 17/96

(54) **Bedienvorrichtung und Verfahren zum Erkennen einer Freigabebedienhandlung**

(71) Anmelder: Siemens Aktiengesellschaft, 80333 München (DE)
(72) Erfinder: Holtschmit, Heinrich, 90592 Schwarzenbruck (DE); Naumann, Ralf, 90513 Zirndorf (DE)

(57) **Zusammenfassung**

Die Erfindung betrifft eine Bedienvorrichtung (100), umfassend ein Eingabefeld (4) mit einem ersten kapazitiven Sensor (1) und einem zweiten kapazitiven Sensor (2), wobei die Sensoren (1,2) mit einem Mittel (5) zur Auswertung einer Kapazitätsänderung der Sensoren (1,2) verbunden sind, und das Mittel (5) ausgestaltet ist für eine Kapazitätsänderung des ersten Sensors (1) ein erstes Ausgangssignal (11) und für eine Kapazitätsänderung des zweiten Sensors (2) ein zweites Ausgangssignal (12) bereitzustellen, wobei durch eine Auswerteeinheit (6), welche ausgestaltet ist einen charakteristischen zeitlichen Verlauf des ersten und zweiten Ausgangssignals (11,12) zu erkennen wodurch eine Freigabebedienhandlung eines Bedieners an dem Eingabefeld (4) erkennbar ist, wobei die Auswerteeinheit (6) ausgestaltet ist nach der erkannten Freigabebedienhandlung ein Freigabesignal (7) zu erzeugen, wobei eine Freigabeeinheit (8) mit der Auswerteeinheit (6) verbunden ist und ausgestaltet ist bei Erhalt des Freigabesignals (7) eine nachfolgende Bedienhandlung innerhalb einer vorbestimmten Zeitspanne für gültig zu erklären.

## Beschreibung

Die Erfindung betrifft eine Bedienvorrichtung, umfassend ein Eingabefeld mit einem ersten kapazitiven Sensor und einem zweiten kapazitiven Sensor, wobei die Sensoren mit einem Mittel zur Auswertung einer Kapazitätsänderung der Sensoren verbunden sind, und das Mittel ausgestaltet ist für eine Kapazitätsänderung des ersten Sensors ein erstes Ausgangssignal und für eine Kapazitätsänderung des zweiten Sensors ein zweites Ausgangssignal bereitzustellen.

Kapazitive Sensoren oder Tasten lassen sich nur schwer gegenüber Fehlbedienungen durch Fremdmedien, wie z.B. Verschmutzungen, ablaufendes Wasser, insbesondere leitfähige Flüssigkeiten und beispielsweise pastöse, feuchte Massen, absichern. Eine Fehlbedienung kann z.B. dann auftreten, wenn über das leitfähige Fremdmedium, welches sich auf oder im Bereich des Sensors befindet, eine Verbindung vom kapazitiven Sensor zu elektrisch leitfähigen, z.B. geerdeten Konstruktionsteilen, wie z.B. ein Gehäuse, besteht. Auch eine Berührung durch einen Bediener der Bedienvorrichtung außerhalb der Sensorfläche kann bei dem Vorhandensein von leitfähigen Flüssigkeiten auf der Bedienvorrichtung zu einer Fehlbedienung führen. Als kritisch wird auch die Reinigung der Bedienfläche, beispielsweise mit einem unterbrechungsfreien Wasserstrahl, der aus einer Düse oder Brause mit Erdpotential austritt, angesehen.

Bei einem Einsatz der Bedienvorrichtung, beispielsweise in der Nahrungs- und Genussmittelindustrie, können sich leitfähige Flüssigkeiten oder pastöse Massen während des Betriebes an der Bedienvorrichtung anlagern. Auch eine Reinigung mit einem Wasserstrahl ist von Zeit zu Zeit erforderlich um die hygienischen Bedingungen einzuhalten. Eine Leitfähigkeit des Fremdmediums muss für eine Fehlbedienung nicht besonders gut sein, beispielsweise genügt Leitungswasser bereits um eine Fehlbedienung auszulösen. Die Wahrscheinlichkeit einer Fehlauslösung steigt jedoch mit der Leitfähigkeit des Fremdmediums, da dann dünnere Schichten bzw. schmalere Spuren ausreichen, um eine elektrisch leitende Verbindung zu geerdeten Teilen herzustellen.

Aus der DE 10 2005 025 021 A1 ist ein Bedienfeld mit einer kapazitiven Sensoreinrichtung bekannt.

Aufgabe der Erfindung ist es, eine Bedienvorrichtung mit kapazitiven Sensoren bereitzustellen, welche bei einer Beeinflussung von leitfähigen Flüssigkeiten keine Fehlbedienung auslöst.

Bei der Bedienvorrichtung, umfassend ein Eingabefeld mit einem ersten kapazitiven Sensor und einem zweiten kapazitiven Sensor, wobei die Sensoren mit einem Mittel zur Auswertung einer Kapazitätsänderung der Sensoren verbunden sind, und das Mittel ausgestaltet ist für eine Kapazitätsänderung des ersten Sensors ein erstes Ausgangssignal und für eine Kapazitätsänderung des zweiten Sensors ein zweites Ausgangssignal bereitzustellen, wird die Aufgabe durch eine Auswerteeinheit gelöst, welche ausgestaltet ist einen charakteristischen zeitlichen Verlauf des ersten und zweiten Ausgangssignals zu erkennen und weiterhin vorzugsweise ausgestaltet ist zu erkennen, ob eine erste Amplitude und eine zweite Amplitude des jeweiligen Ausgangssignals innerhalb eines vorgegebenen Bereiches liegt, wodurch eine Freigabebedienhandlung eines Bedieners an dem Eingabefeld erkennbar ist, wobei die Auswerteeinheit ausgestaltet ist nach der erkannten Freigabebedienhandlung ein Freigabesignal zu erzeugen, wobei eine Freigabeeinheit mit der Auswerteeinheit verbunden ist und ausgestaltet ist bei Erhalt des Freigabesignals eine nachfolgende Bedienhandlung innerhalb einer vorbestimmten Zeitspanne für gültig zu erklären. Mit dieser Ausgestaltung können Fehlauslösungen kapazitiver Sensoren verhindert werden. Durch die Auswertung der zeitlichen Ausgangssignalverläufe der in der Bedienvorrichtung zur Bedienung einer Maschine, beispielsweise bereits vorhandenen kapazitiven Sensoren kann auf eine gewollte Freigabebedienhandlung zurückgeschlossen werden. Die kapazitiven Sensoren müssen nicht zwingend kapazitive Sensoren der Bedienvorrichtung zur Bedienung der Maschine sein, welche zum Bedienen einer Maschine genutzt werden, es können auch versteckte Sensoren oder Sensoren, welche unterhalb von Sensoren liegen, welche zur Bedienung des Gerätes genutzt werden, sein.

Die kapazitiven Sensoren stellen ein analoges Ausgangssignal zur Verfügung, welches sowohl in der Amplitude als auch in seinem zeitlichen Verlauf ausgewertet wird. Bei einem Überstreichen von zwei nebeneinander liegenden kapazitiven Sensoren, beispielsweise mit einem Finger einer menschlichen Hand, erhält man einen charakteristischen Signalverlauf, welcher ausgewertet werden kann. Die Ausgangssignale der zwei Tasten werden nacheinander auf ein Maximum ansteigen und wieder auf ein Minimum abfallen, welches ausgewertet wird.

In einer weiterführenden Ausgestaltung weist die Bedienvorrichtung die Auswerteeinheit derart auf, dass die Auswerteeinheit ausgestaltet ist, den charakteristischen zeitlichen Verlauf der Ausgangssignale zu erkennen, welcher aufgrund einer Wischbewegung entsteht, wobei die Wischbewegung über den ersten Sensor und den zweiten Sensor hinwegführt, dabei ist die Auswerteeinheit ausgestaltet zu prüfen, ob der bei der Wischbewegung über den ersten Sensor entstehende zeitliche Verlauf des ersten Ausgangssignals innerhalb des Bereiches liegt, welcher durch einen minimalen und einen maximalen Referenzsignalverlauf begrenzt ist, weiterhin ist die Auswerteeinheit ausgestaltet nach erfolgreicher Prüfung des ersten Ausgangssignals das zweite Ausgangssignal auf dieselbe Art zu prüfen. Zum Erzeugen des Freigabesignals wischt der Bediener beispielsweise mit einem Finger über die kapazitiven Sensoren. Diese Wischbewegung sollte vorteilhafter Weise mit einer bestimmten Wischgeschwindigkeit erfolgen.

Eine weiter optimierte Ausgestaltung sieht bei der Bedienvorrichtung vor, dass die nachfolgende Bedienhandlung über den ersten Sensor und/oder den zweiten Sensor abgefragt werden kann oder zur Abfrage der nachfolgenden Bedienhandlung sind in der Bedienvorrichtung weitere kapazitive Sensoren abzufragen.

Für die Ausgestaltung von weiteren kapazitiven Sensoren zur Abfrage der nachfolgenden Bedienhandlung ist der erste Sensor und der zweite Sensor innerhalb des Eingabefeldes mit je einem weiteren kapazitiven Sensor angeordnet oder der erste und der zweite Sensor sind in ihrem Eingabefeld angeordnet und die weiteren kapazitiven Sensoren in einem zusätzlichen Bedienfeld angeordnet.

Eine weitere Ausgestaltung sieht zur besseren Rückmeldung an einen Bediener vor, dass zur Bestätigung eines erfolgreich erkannten Ausgangssignalverlaufs dem ersten Sensor und dem zweiten Sensor je ein Signalisierungsmittel zugeordnet ist. Für ein besseres Feedback an den Bediener kann der Wischvorgang, beispielsweise per LEDs z.B. einer LED pro überstrichenen kapazitiven Sensor, visualisiert werden. Auch ist es sinnvoll, wenn die Meldung einer erfolgreichen Freigabe in ihrer Dauer begrenzt ist. Ein nicht erkannter Freigabeversuch könnte beispielsweise durch ein Blinken der zugehörigen LED dargestellt werden.

Ein Auslösen von einer Fehlbedienung kann dadurch verbessert werden, wenn zu dem ersten Sensor und dem zweiten Sensor ein dritter Sensor in einer Reihe derart angeordnet ist, dass alle drei Sensoren mit einer Wischbewegung überstrichen werden müssen, wobei die Auswerteeinheit weiterhin ausgestaltet ist, nach dem, in einer zeitlichen Abfolge hintereinander liegenden, Erkennen des ersten Ausgangssignals und des zweiten Ausgangssignals, ein drittes Ausgangssignal des dritten Sensors zu erkennen und erst nach einer Prüfung, ob die bei der Wischbewegung über die drei Sensoren entstehenden zeitlichen Verläufe der drei Ausgangssignale alle innerhalb des Bereiches liegen, dass Freigabesignal zu erzeugen. Dazu sollten sich die Kurven der Signalverläufe der Ausgangssignale der einzelnen kapazitiven Sensoren in engen Toleranzen zu einem Idealwert eines Signalverlaufes liegen. Liegt ein Signalverlauf außerhalb dieser Toleranzen, ist er nicht als eine Freigabe zu bewerten. Sind weitere Sensoren vorhanden, wie z.B. Guard-Ringe, können diese mit einbezogen werden. Eine Auswertestrategie muss so gewählt werden, dass die versehentliche Erkennung eines Fremdmediums als eine Wischbewegung praktisch auszuschließen ist. Sollten z.B. Permanente oder "unlogische" Betätigungsmuster erkennbar sein, wird die Freigabe durch die Wischbewegung für eine vorbestimmte Zeit gesperrt.

Für ein Verfahren zum Erkennen einer Freigabebedienhandlung in einem Eingabefeld einer Bedienvorrichtung, wobei ein erster kapazitiver Sensor und ein zweiter kapazitiver Sensor durch einen Bediener innerhalb des Eingabefeldes beeinflusst werden, wobei über ein Mittel zur Auswertung einer Kapazitätsänderung der Sensoren ein erstes Ausgangssignal für eine Kapazitätsänderung des ersten Sensors und ein zweites Ausgangssignal für eine Kapazitätsänderung des zweiten Sensors bereitgestellt wird, wird die Aufgabe der vorliegenden Erfindung dadurch gelöst, dass ein charakteristischer zeitlicher Verlauf des ersten und des zweiten Ausgangssignals daraufhin überprüft wird, ob er innerhalb eines vorgegebenen Bereiches liegt, wodurch die Freigabebedienhandlung des Bedieners an dem Eingabefeld erkennbar wird, nach der erkannten Freigabebedienhandlung wird ein Freigabesignal erzeugt und eine nachfolgende Bedienhandlung wird innerhalb einer vorbestimmten Zeitspanne für gültig erklärt und/oder ob eine erste Amplitude des ersten Ausgangssignals und eine zweite Amplitude des zweiten Ausgangssignals innerhalb des vorgegebenen Bereiches liegt.

Weiterhin ist es vorteilhaft, wenn der charakteristische zeitliche Verlauf der Ausgangssignale erkannt wird, welcher aufgrund einer Wischbewegung mit einem Bedienobjekt über dem ersten Sensor und dem zweiten Sensor hinweg entsteht, dabei wird geprüft, ob der bei der Wischbewegung über den ersten Sensor entstehende zeitliche Verlauf des ersten Ausgangssignals innerhalb des Bereiches liegt, welcher durch einen minimalen und einen maximalen Referenzsignalverlauf begrenzt ist, nach erfolgreicher Prüfung des ersten Ausgangssignals wird das zweite Ausgangssignal auf dieselbe Art geprüft.

Weiterhin ist es vorteilhaft, wenn bei einem Erkennen einer ungültigen Freigabebedienhandlung das Eingabefeld für eine bestimmbare Zeitdauer inaktiv geschaltet wird.

Eine weitere Ausgestaltungsvariante eines Verfahrensschrittes sieht vor, dass ausgehend von dem bereits erfassten zeitlichen Verlauf des ersten Ausgangssignals der Referenzsignalverlauf für den folgenden zeitlichen Verlauf des zweiten Ausgangssignals dynamisch angepasst wird. Es können unterschiedliche Auswertungsstrategien angewandt werden, so könnte die Startgeschwindigkeit ausgewertet werden, die unterschiedliche Amplitude, welche entsteht, wenn ein Bediener z.B. mit einem dicken oder einen dünnen Finger die kapazitiven Sensoren berührt. Die Zeiträume der aufeinanderfolgenden Signalverläufe können ebenfalls dynamisch ausgewertet werden, so sollte eine erste Zeit nach einem annähernden Abklingen des ersten Signalverlaufes im Bereich von t1 = 0,3-0,5 sec liegen, wobei dann eine zweite Zeit t2 beispielsweise im Bereich von (0,9-1,1) sec ● t1 liegt. Generell ist es vorteilhaft, wenn für das erste Ausgangssignal in einem ersten Intervall bereits eine Freigabe erkannt wurde, ein zweites Intervall für das Erkennen des zweiten Ausgangssignals dynamisch und in Abhängigkeit von dem ersten Intervall zu definieren.

Um eine Fehlbedienung an den kapazitiven Sensoren noch besser auszuschließen, wird der zeitliche Verlauf eines dritten Ausgangssignals eines dritten Sensors ausgewertet, wobei alle drei Sensoren mit der Wischbewegung überstrichen werden, wobei nach dem in einer zeitlichen Abfolge hintereinander liegenden Erkennen des ersten Ausgangssignals und des zweiten Ausgangssignals das dritte Ausgangssignal des dritten Sensors erkannt wird und erst nach einer Prüfung, ob die bei der Wischbewegung über die drei Sensoren entstehenden zeitlichen Verläufe der drei Ausgangssignale alle innerhalb des Bereiches liegen, das Freigabesignal erzeugt wird.

Zusammenfassend kann gesagt werden, dass durch die Auswertung der charakteristischen zeitlichen Signalverläufe, insbesondere von drei hintereinander liegenden kapazitiven Sensoren, welche mit einer Wischbewegung überstrichen werden, dass es bei dem Verfahren bzw. der Bedienvorrichtung unwahrscheinlich wird, dass Fremdmedien, wie z.B. leitende Flüssigkeiten, die kapazitiven Sensoren genau nach dem erforderlichen Muster beeinflussen. Das Steuern einer Maschine mit einer Bedienvorrichtung wird demnach sicherer.

Die Zeichnung zeigt ein Ausführungsbeispiel einer Bedienvorrichtung mit kapazitiven Sensoren und erläutert anhand zeitlicher Ausgangssignalverläufe der kapazitiven Sensoren das Auswertungsverfahren.

Es zeigt
- FIG 1: eine Bedienvorrichtung angeschlossen an eine Maschine,
- FIG 2: die Bedienvorrichtung in einer schematischen Detailansicht und
- FIG 3: die entstehenden zeitlichen Ausgangssignalverläufe bei einer Wischbewegung über die kapazitiven Sensoren.

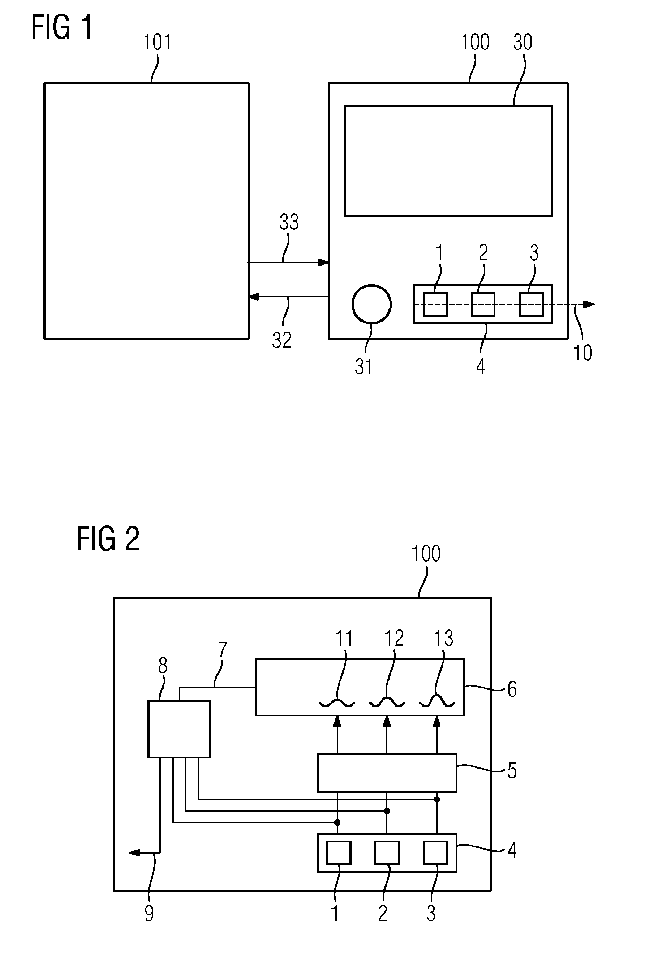

Gemäß FIG 1 ist eine Bedienvorrichtung 100, welche an einer zu bedienenden Maschine 101 angeschlossen ist, dargestellt. Die Bedienvorrichtung 100 weist ein Eingabefeld 4 mit einem ersten kapazitiven Sensor 1, einem zweiten kapazitiven Sensor 2 und einem dritten kapazitiven Sensor 3 auf. Nach dem Stand der Technik konnte durch Berühren eines der kapazitiven Sensoren 1,2,3 zuvor direkt eine Bedienhandlung ausgeführt werden, welche mittels eines Steuerbefehls über Steuerdaten 32 direkt zu der Maschine 101 gelangte.

Da aber insbesondere bei kapazitiven Sensoren durch Fremdmedien, wie beispielsweise leitfähige Flüssigkeiten, leitfähige pastöse Massen, Verschmutzungen, ablaufendes Wasser, Fehlbedienungen an der Bedienvorrichtung 100 entstehen können, welche als Steuerdaten 32 zu der Maschine 101 abgesetzt werden und ein ungewolltes Steuern der Maschine 101 auslösen, ist vorgesehen, dass durch eine bestimmte Freigabebedienhandlung an den drei Sensoren 1,2,3 eine Freigabe für das Berühren eines der kapazitiven Sensoren 1,2,3 ausgelöst wird. Vorteilhafter Weise wird dazu eine Wischbewegung 10 von links nach rechts über die drei kapazitiven Sensoren 1,2,3 von einem Bediener ausgeführt.

War diese Freigabebedienhandlung mit der Wischbewegung 10 erfolgreich, so könnte beispielsweise über ein in die Bedienvorrichtung 100 eingebautes Display 30 die erfolgreiche Freigabebedienhandlung angezeigt werden und ein Bediener könnte nun, vorzugsweise gezielt, eine der drei als kapazitive Tasten ausgestaltete Sensoren 1,2,3 drücken. So könnte beispielsweise der erste kapazitive Sensor 1 einen Startbefehl auslösen, der zweite kapazitive Sensor 2 einen Initialisierungsbefehl für die Maschine 101 auslösen und der dritte kapazitive Sensor 3 einen Stoppbefehl für die Maschine 101 auslösen. Über Zustandsdaten 33 könnte der Stoppzustand der Maschine 101 abgefragt werden.

Sollte die Maschine 101 nicht entsprechend der Bedienung arbeiten oder eine gravierende Fehlfunktion an der Maschine 101 aufgetreten sein, so weist die Bedienvorrichtung 100 zusätzlich einen Notaus-Schalter 31 auf, welcher im betätigten Zustand das gesamte Bedienfeld und die Maschine 101 ausschaltet.

Mit der FIG 2 wird die Ausgestaltung der Bedienvorrichtung 100 näher aufgezeigt. An das Eingabefeld 4 mit dem ersten kapazitiven Sensor 1, dem zweiten kapazitiven Sensor 2 und dem dritten kapazitiven Sensor 3 ist ein Mittel 5 zur Auswertung einer Kapazitätsänderung der Sensoren 1,2,3 angeschlossen. Das Mittel 5 zur Auswertung der Kapazitätsänderung ist ausgestaltet für eine Kapazitätsänderung des ersten Sensors 1 ein erstes Ausgangssignal 11, für eine Kapazitätsänderung des zweiten Sensors 2 ein zweites Ausgangssignal 12 und für eine Kapazitätsänderung des dritten kapazitiven Sensors 3 ein drittes Ausgangssignal 13 bereitzustellen.

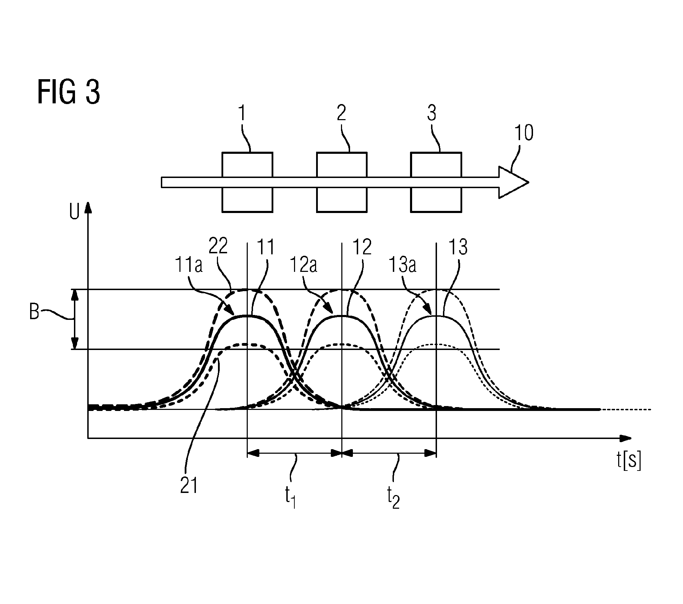

Das Mittel 5 zur Auswertung der Kapazitätsänderung leitet die drei Ausgangssignale 11,12,13 an eine Auswerteeinheit 6 weiter, welche ausgestaltet ist, einen charakteristischen zeitlichen Verlauf des ersten, zweiten und dritten Ausgangssignals 11,12,13 zu erkennen. Dabei ist die Auswerteeinheit 6 weiterhin dazu ausgestaltet, zu erkennen, ob eine erste Amplitude 11a (siehe FIG 3), eine zweite Amplitude 12a und eine dritte Amplitude 13a der jeweiligen Ausgangssignale 11,12,13 innerhalb eines vorgegebenen Bereiches B liegt. War die Erkennung der charakteristischen zeitlichen Verläufe der Ausgangssignale 11,12,13 erfolgreich, so wird eine Freigabebedienhandlung eines Bedieners an dem Eingabefeld 4 erkannt, wobei zusätzlich die Auswerteeinheit 6 ausgestaltet ist, nach der erkannten Freigabebedienhandlung ein Freigabesignal 7 zu erzeugen, wobei weiterhin eine Freigabeeinheit 8 mit der Auswerteeinheit 6 verbunden ist und ausgestaltet ist, bei Erhalt des Freigabesignals 7 eine nachfolgende Bedienhandlung innerhalb einer vorbestimmten Zeitspanne für gültig zu erklären. Dazu ist die Freigabeeinheit 8 ausgestaltet, ein Gültigkeitssignal 9 zu erzeugen, welches für ein Bedienen der kapazitiven Sensoren 1,2,3 ausgewertet wird.

Bei dieser Ausgestaltungsvariante der Bedienvorrichtung 100 werden die kapazitiven Sensoren 1,2,3 sowohl für das Erkennen der Freigabebedienhandlung als auch für das Bedienen der Maschine 101 genutzt. Dazu sind die kapazitiven Sensoren 1,2,3 über Signalleitungen mit der Freigabeeinheit 8 verbunden und erst nach Erzeugen des Freigabesignals 9 können die Signalverläufe der kapazitiven Sensoren 1,2,3 durch die Freigabeeinheit 8 als gültige Signale ausgewertet werden.

Mit der FIG 3 wird eine mögliche Auswertungsstrategie der Signalverläufe der kapazitiven Sensoren 1,2,3 aufgezeigt. Oberhalb der Signalverläufe sind symbolisch die drei Sensoren 1,2,3 in einer Reihe angeordnet und können mit einer Wischbewegung 10 von links nach rechts durch ein Bedienobjekt überstrichen werden, wodurch letztendlich eine Freigabebedienhandlung erkannt wird und die Bedienvorrichtung für eine nachfolgende Bedienhandlung freigegeben wird.

Über der Zeit t sind die charakteristischen zeitlichen Verläufe des ersten Ausgangssignals 11, des zweiten Ausgangssignals 12 und des dritten Ausgangssignals 13 dargestellt. Bei einem Überstreichen des ersten kapazitiven Sensors 1 in Richtung der Wischbewegung 10 steigt der Signalverlauf des ersten Ausgangssignals 11 von einem Minimum, beispielsweise einem Grundrauschen stetig an bis der charakteristische Signalverlauf ein Maximum erreicht und danach wieder kontinuierlich auf die Grundrauschlinie abfällt. Vorausgesetzt man hat eine Wischbewegung 10 mit einer kontinuierlichen Geschwindigkeit, so ergibt sich der dargestellte symmetrische Verlauf der Ausgangssignale 11,12,13 in dem Diagramm unter den Sensoren 1,2,3. Das Verfahren für das Erkennen der Signalverläufe ist nicht auf symmetrische Verläufe eingeschränkt, es wäre auch denkbar, dass sich die Signalverläufe überlappen.

Jeder Ausgangssignalverlauf 11,12,13 ist umgeben von einem minimalen Referenzsignalverlauf 21 und einem maximalen Referenzsignalverlauf 22, welche die zeitlichen Signalverläufe der Ausgangssignale 11,12,13 wie eine Hüllkurve umgeben. Durch die Referenzsignalverläufe 21,22 wird im Bereich der maximalen Amplitude ein Bereich B aufgespannt, in welchem sich für eine gültig zu erkennende Freigabebedienhandlung die zeitlichen Ausgangssignalverläufe 11,12,13 der drei kapazitiven Sensoren 1,2,3 befinden sollten.

Durch das hintereinander liegende Prüfen der Ausgangssignalverläufe 11,12,13 in der Reihenfolge erstes Ausgangssignal 11, zweites Ausgangssignal 12 und anschließend drittes Ausgangssignal 13 wird es nahezu unwahrscheinlich, dass Fremdmedien, wie z.B. leitende Flüssigkeiten auf den kapazitiven Sensoren 1,2,3, diese derart beeinflussen, dass eine Fehlbedienung an der Bedienvorrichtung 100 auftritt.

In Abwandlung zu einer gradlinigen Wischbewegung ist ebenso eine Kurvenform möglich. Es müsste dann mit einem Finger beispielsweise eine Kurve überstrichen werden, insbesondere eine L-, S-, V-förmige Kurve. Die entsprechenden Sensoren für eine Freigabebedienhandlung müssen dann entsprechend der gewählten Kurvenform in dem Eingabefeld angeordnet sein. Es werden dann vorzugsweise mehr als drei Sensoren eingesetzt.

Auch könnten zwei parallele Reihen von Sensoren angeordnet sein, die gleichzeitig mit zwei Fingern überstrichen werden müssen.

Ein zusätzlicher Verfahrensschritt kann auch vorsehen, dass wenn die Sensoren erfolgreich freigegeben wurden, diese nach Betätigung eines Sensors a) sofort gesperrt werden, b) bis zum Ablauf der Freigabedauer weiter freigegeben sind oder c) die Freigabedauer verlängert wird.

## Patentansprüche

1. Bedienvorrichtung (100), umfassend
ein Eingabefeld (4) mit
einem ersten kapazitiven Sensor (1) und
einem zweiten kapazitiven Sensor (2), wobei die Sensoren (1,2) mit einem Mittel (5) zur Auswertung einer Kapazitätsänderung der Sensoren (1,2) verbunden sind, und das Mittel (5) ausgestaltet ist für eine Kapazitätsänderung des ersten Sensors (1) ein erstes Ausgangssignal (11) und für eine Kapazitätsänderung des zweiten Sensors (2) ein zweites Ausgangssignal (12) bereitzustellen,
**gekennzeichnet, durch** eine Auswerteeinheit (6), welche ausgestaltet ist einen charakteristischen zeitlichen Verlauf des ersten und zweiten Ausgangssignals (11,12) zu erkennen wodurch eine Freigabebedienhandlung eines Bedieners an dem Eingabefeld (4) erkennbar ist, wobei die Auswerteeinheit (6) ausgestaltet ist nach der erkannten Freigabebedienhandlung ein Freigabesignal (7) zu erzeugen, wobei eine Freigabeeinheit (8) mit der Auswerteeinheit (6) verbunden ist und ausgestaltet ist bei Erhalt des Freigabesignals (7) eine nachfolgende Bedienhandlung innerhalb einer vorbestimmten Zeitspanne für gültig zu erklären.

2. Bedienvorrichtung nach Anspruch 1, wobei die Auswerteeinheit (6) weiterhin ausgestaltet ist zu erkennen, ob eine erste Amplitude (11a) und eine zweite Amplitude (12a) der jeweiligen Ausgangsspannung (11,12) innerhalb eines vorgegebenen Bereiches (B) liegt.

3. Bedienvorrichtung (100) nach Anspruch 1 oder 2, wobei die Auswerteeinheit (6) ausgestaltet ist den charakteristischen zeitlichen Verlauf der Ausgangssignale (11,12) zu erkennen, welcher aufgrund einer Wischbewegung (10) entsteht, wobei die Wischbewegung (10) über den ersten Sensor (1) und den zweiten Sensor (2) hinweg führt, dabei ist die Auswerteeinheit (6) ausgestaltet zu prüfen, ob der bei der Wischbewegung über den ersten Sensor (1) entstehende zeitliche Verlauf des ersten Ausgangssignals (11) innerhalb des Bereichs (B) liegt, welcher durch einen minimalen und einen maximalen Referenzsignalverlauf (21,22) begrenzt ist, weiterhin ist die Auswerteeinheit (6) ausgestaltet nach erfolgreicher Prüfung des ersten Ausgangssignals (11), das zweite Ausgangssignal (12) auf dieselbe Art zu prüfen.

4. Bedienvorrichtung (100) nach einem der Ansprüche 1 bis 3, ausgestaltet um die nachfolgende Bedienhandlung über den ersten Sensor (1) und/oder den zweiten Sensor (2) abzufragen oder um die nachfolgende Bedienhandlung über weitere kapazitive Sensoren abzufragen.

5. Bedienvorrichtung (100) nach Anspruch 4, wobei bei der Ausgestaltung mit weiteren kapazitiven Sensoren zur Abfrage der nachfolgenden Bedienhandlung der erste Sensor (1) und der zweite Sensor (2) innerhalb des Eingabefeldes (4) mit je einem weiteren kapazitiven Sensor angeordnet ist oder der erste und zweite Sensor (1,2) in ihrem Eingabefeld (4) angeordnet ist und die weiteren kapazitiven Sensoren in einem zusätzlichen Bedienfeld angeordnet sind.

6. Bedienvorrichtung (100) nach einem der Ansprüche 1 bis 5, wobei zur Bestätigung eines erfolgreich erkannten Ausgangssignalverlaufs dem ersten Sensor (1) und dem zweiten Sensor (2) je ein Signalisierungsmittel zugeordnet ist.

7. Bedienvorrichtung (100) nach einem der Ansprüche 1 bis 6, wobei zu dem ersten Sensor (1) und dem zweiten Sensor (2) ein dritter Sensor (3) in einer Reihe derart angeordnet ist, dass alle drei Sensoren (1,2,3) mit einer Wischbewegung (10) überstrichen werden, wobei die Auswerteeinheit (6) weiterhin ausgestaltet ist nach dem in einer hintereinanderliegenden zeitlichen Abfolge das Erkennen des ersten Ausgangssignal (11) und des zweiten Ausgangssignals (12) ein drittes Ausgangssignal (13) des dritten Sensors (3) zu erkennen und erst nach einer Prüfung, ob die bei der Wischbewegung (10) über die drei Sensoren (1,2,3) entstehenden zeitlichen Verläufe der drei Ausgangssignale (11,12,13) alle innerhalb des Bereiches (B) liegen, um ein Freigabesignal (7) zu erzeugen.

8. Verfahren zum Erkennen einer Freigabebedienhandlung in einem Eingabefeld (4) einer Bedienvorrichtung (100), wobei ein erster kapazitiver Sensor (1) und ein zweiter kapazitiver Sensor (2) durch einen Bediener innerhalb des Eingabefeldes (4) beeinflusst werden, wobei über ein Mittel (5) zur Auswertung einer Kapazitätsänderung der Sensoren (1,2) ein erstes Ausgangssignals (11) für eine Kapazitätsänderung des ersten Sensors (1) und ein zweites Ausgangssignal (12) für eine Kapazitätsänderung des zweiten Sensors (2) bereitgestellt wird, **dadurch gekennzeichnet, dass** ein charakteristischer zeitlicher Verlauf des ersten und des zweiten Ausgangssignals (11,12) daraufhin überprüft wird, ob er innerhalb eines vorgegebenen Bereiches (B) liegt, wodurch die Freigabebedienhandlung des Bedieners an dem Eingabefeld (4) erkennbar wird, nach der erkannten Freigabebedienhandlung wird ein Freigabesignal (7) erzeugt und eine nachfolgende Bedienhandlung wird innerhalb einer vorbestimmten Zeitspanne für gültig erklärt.

9. Verfahren nach Anspruch 8, wobei überprüft wird, ob eine erste Amplitude (11a) des ersten Ausgangssignals (11) und eine zweite Amplitude (12a) des zweiten Ausgangssignals (12) innerhalb des vorgegebenen Bereiches (B) liegen.

10. Verfahren nach Anspruch 8 oder 9, wobei der charakteristische zeitliche Verlauf der Ausgangssignale (11,12) erkannt wird, welcher aufgrund einer Wischbewegung (10) mit einem Bedienobjekt über den ersten Sensor (1) und den zweiten Sensor (2) hinweg entsteht, dabei wird geprüft, ob der bei der Wischbewegung (10) über den ersten Sensor (1) entstehende zeitliche Verlauf des ersten Ausgangssignals (11) innerhalb des Bereiches (B) liegt, welcher durch einen minimalen und einen maximalen Referenzsignalverlauf (21,22) begrenzt ist, nach erfolgreicher Prüfung des ersten Ausgangssignals (11) wird das zweite Ausgangssignal (12) auf dieselbe Art geprüft.

11. Verfahren nach einem der Ansprüche 8 bis 10, wobei bei einem Erkennen einer ungültigen Freigabebedienhandlung das Eingabefeld (4) für eine bestimmbare Zeitdauer inaktiv geschaltet wird.

12. Verfahren nach Anspruch 10 oder 11, wobei ausgehend von dem bereits erfassten zeitlichen Verlauf des ersten Ausgangssignals (11) der Referenzsignalverlauf (21,22) für den folgenden zeitlichen Verlauf des zweiten Ausgangssignals (12) dynamisch angepasst wird.

13. Verfahren nach einem der Ansprüche 8 bis 12, wobei der zeitliche Verlauf eines dritten Ausgangssignals (13) eines dritten Sensors (3) ausgewertet wird, wobei alle drei Sensoren (1,2,3) mit der Wischbewegung (10) überstrichen werden, wobei nach dem in einer zeitlichen Abfolge hintereinanderliegenden Erkennen des ersten Ausgangssignals (11) und des zweiten Ausgangssignals (12) das dritte Ausgangssignal (13) des dritten Sensors (3) erkannt wird und erst nach einer Prüfung, ob die bei der Wischbewegung (10) über die drei Sensoren (1,2,3) entstehenden zeitlichen Verläufe der drei Ausgangssignale (11,12,13) alle innerhalb des Bereiches (B) liegen, dass ein Freigabesignal (7) erzeugt wird.
